# EUROPEAN PATENT APPLICATION

(11) **EP 2 784 199 A1**
(43) Date of publication of application: **01.10.2014**
(21) Application number: 13001623.1
(22) Date of filing: 28.03.2013
(51) Int. Cl.: D03D 15/00, H01R 4/14, H05K 1/03, A61B 5/00

(54) **Woven electrical connection structure**

(71) Applicant: King's Metal Fiber Technologies Co., Ltd., Taipei City (TW)
(72) Inventor: Huang, Hong Hsu, Taipei, Taiwan (TW); Peng, Jung Hsiang, Taipei, Taiwan (TW)
(74) Representative: Bobbert & Partner

(57) **Abstract**

A woven electrical connection structure (4) including a first conductive yarn (11), a conductor (21) and a fastening string (32) is provided. The conductor is directly stacked on and electrically connected to the first conductive yarn. The fastening string can be further applied to sew the conductor on the first conductive yarn. Additionally, the conductor can also be replaced by a second conductive yarn (22). Similarly, the second conductive yarn can be stacked on or wound around the first conductive yarn to make an electrical connection. The fastening wire can be applied to sew the first conductive yarn and the second conductive yarn together.

## Description

### BACKGROUND OF THE INVENTION

### Field of the Invention

The present invention provides an electrical connection structure, and more particularly, to a woven electrical connection structure that forms an electrical connection through weaving.

### Descriptions of the Related Art

Conventional textile industries have not only had to continuously make technical innovations, but also have had to collaborate with other industries to keep up with the increased demands and expectations of consumers. Particularly, with the rapid growth of the electronic industry, applications that adopt textiles with electronic products have become mainstay over recent years. That is, textiles are no longer just for warmth and coverage, but have now integrated with electronic products to increase its functions, such as adding entertaining features. However, conventional electronic products are not as flexible and washable as textiles, and also rarely, have an aesthetic appearance, therefore it is a challenge to combine the technologies of the two industries together.

Generally, the combination of an electronic component (e.g., an LED) or a circuit board with a textile is realized by placing a metal wire in the textile, with the metal wire electrically connecting the metal wire and the textile to the electronic component and power source. The metal wire may be connected to the electronic component through soldering or by means of a pair of male and female connectors. However, in such a design, the electronic component must be detached each time the textile is to be washed so that the electrical connection of the pins to the metal wire will not be disrupted or short-circuited and so that the pins will also not pierce the outer surface of the textile after the textile has been washed or stretched for a plurality of times.

Accordingly, it is important to provide a structure that forms an electrical connection through weaving and to apply such a structure to textiles so that the combination of textiles with electronic components can be made more flexible to further improve the aesthetic appearance and utility of the textiles.

### SUMMARY OF THE INVENTION

To achieve the aforesaid objective, the present invention provides a woven electrical connection structure, which comprises a first conductive yarn, a conductor and a connecting conductive wire wound around the first conductive yarn. By simply having the conductor come into contact or directly stacked onto the connecting conductive wire, the conductor can be electrically connected to the first conductive yarn through the connecting conductive wire. Portions of the first conductive yarn or the connecting conductive wire that are not electrically connected may be partially covered with an insulation material. The connecting conductive wire is sewn or wound around the conductive yarn via any weaving method, such as tatting, knitting, machine sewing, needling, hand sewing or stitching,.

Furthermore, an adhesive may also be applied between the conductor and the connecting conductive wire to enhance the overall firmness, conductivity or insulativity. In other embodiments, the conductor may be replaced by a second conductive wire, which is similar to the first conductive yarn. Similarly, by stacking the second conductive yarn onto the connecting conductive wire, the electrical connection with the first conductive yarn can be achieved.

A woven electrical connection structure according to another embodiment of the present invention comprises a first conductive yarn and a conductor. The conductor is directly stacked onto the first conductive yarn, and a fastening string is sewn and wound around the first conductive yarn and the conductor. As described above, the conductor may also be replaced with a second conductive yarn. The two conductive yarns are wound around or stacked on each other through weaving, and are further fixed through weaving by means of the fastening string.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG. 1** is a schematic view of the first embodiment of the present invention;
**FIG. 2** is a schematic view of another aspect of the first embodiment of the present invention;
**FIG. 3** is a schematic view of a further aspect of the first embodiment of the present invention;
**FIG. 4** is a schematic view of the second embodiment of the present invention;
**FIG. 5** is a schematic view of another aspect of the second embodiment of the present invention;
**FIG. 6** is a schematic view of a further aspect of the second embodiment of the present invention;
**FIG. 7** is a schematic view of the third embodiment of the present invention;
**FIG. 8** is a schematic view of another aspect of the third embodiment of the present invention;
**FIG. 9** is a schematic view showing the third embodiment of **FIG. 7** with a fastening string; and
**FIG. 10** is a schematic view showing the aspect of **FIG. 8** with a fastening string.

### DESCRIPTION OF THE PREFERRED EMBODIMENT

In the following descriptions, the present invention will be explained with reference to several embodiments thereof. However, the description of these embodiments is only for the purpose of illustration rather than to limit the present invention. It shall be appreciated that in the following embodiments and attached drawings, elements not directly related to the present invention are omitted from depiction; and dimensional and positional relationships among individual elements in the attached drawings are illustrated only for the ease of understanding but not to limit the actual scale.

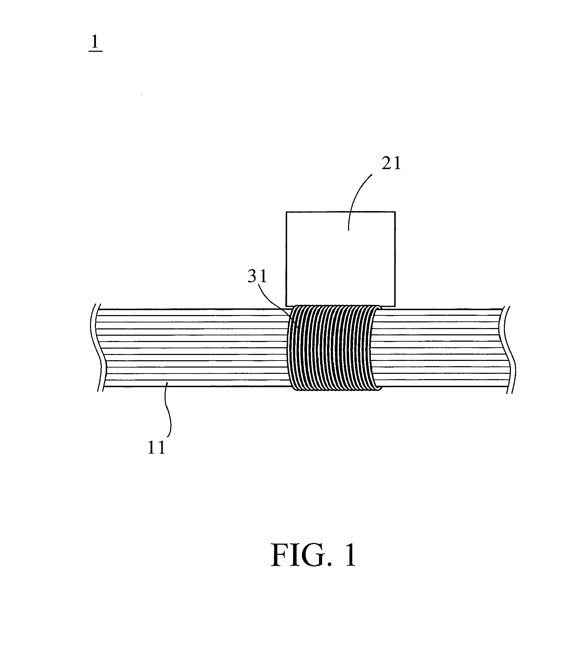

The first embodiment of the present invention is shown in **FIG. 1****,** which is a schematic view of an electrical connection structure **1.** The electrical connection structure **1** comprises a first conductive yarn **11,** a conductor **21** and a connecting conductive wire **31.** The connecting conductive wire **31** is directly sewn and wound around the first conductive yarn **11.** The conductor **21** can be directly stacked on the connecting conductive wire **31** to be electrically connected to the first conductive yarn **11** through the connecting conductive wire **31.**

In other implementations, the first conductive yarn may have an end. The connecting conductive wire is sewn and wound around the end, and is electrically connected to the conductor that is directly stacked on the connecting conductive wire. As used herein, the term "end" refers to either region at the two ends of the first conductive yarn; however, the connecting conductive wire may also be wound around any electrically connectable portion of the conductive yarn depending on the requirements and designs so that the conductive yarn is electrically connected to the conductor stacked on the connecting conductive wire.

The weaving and winding method used in this embodiment may be tatting, knitting, machine sewing, needling, hand sewing or stitching, by which the connecting conductive wire **31** is sewn or wound around the first conductive yarn **11.** In other implementations, an adhesive may also be applied between the conductor and the connecting conductive wire to enhance the overall firmness, conductivity or insulativity. In this embodiment, the adhesive may be a conductive adhesive or an insulative adhesive, and the conductor **21** may be a surface mount device (SMD) or a common electronic component.

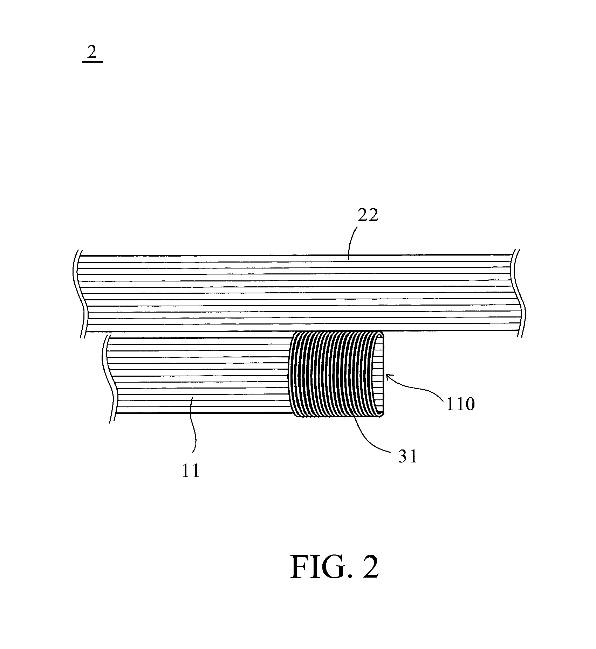

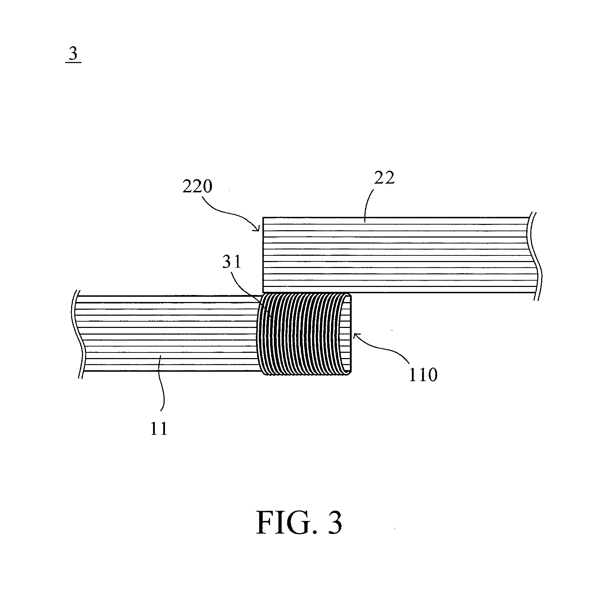

In other implementations of this embodiment, the conductor of the electrical connection structure may be further replaced with a construction similar to the first conductive yarn **11,** as shown in **FIG. 2** and **FIG. 3****.** In these implementations, another electrical connection structure **2** is shown. A second conductive yarn **22** is directly stacked on the connecting conductive wire **31** to be electrically connected to the first conductive yarn **11** through the connecting conductive wire **31.** As shown in **FIG. 2****,** the connecting conductive wire **31** is sewn or wound around the first end **110** of the first conductive yarn **11.** Further, as shown in **FIG. 3**, the second conductive yarn **22** also has a second end **220,** and the connecting conductive wire **31** is also sewn and wound around the first end **110** of the first conductive yarn **11** so that by means of the connecting conductive wire **31** and the second end **220** of the second conductive yarn **22** directly stacked thereon, an electrical connection can be formed between the two ends **110, 220.**

The first conductive yarn **11** and the second conductive yarn **22** described in the aforesaid embodiment and this implementation may be a metal yarn. The metal yarn may be made of stainless-steel fibers, carbon fibers, sputtered fibers or combinations thereof. Alternatively, the metal yarn may further have polyethyleneterephthalate (PET), polyester fibers, cotton, polyurethane (PU) or combination thereof.

Similarly, in the implementations shown in **FIG. 2** and **FIG. 3****,** an adhesive may also be applied between the first conductive yarn **11** and the second conductive yarn **22** to enhance the overall firmness, conductivity or insulativity. The adhesive may be a conductive adhesive or an insulative adhesive as needed. Furthermore, other component arrangements, such as materials and combinations in the implementations shown in **FIG. 2** and **FIG. 3** are all similar to those of the electrical connection structure **1** of the first embodiment, and thus, will not be further described herein.

As can be known from **FIG. 2** and **FIG. 3****,** although these implementations depict the end(s) as an example, the present invention is not limited thereto. Therefore, people skilled in the art may also form an electrical connection by means of any electrically connectable portions of the first conductive yarn **11** or the second conductive yarn **22** as needed.

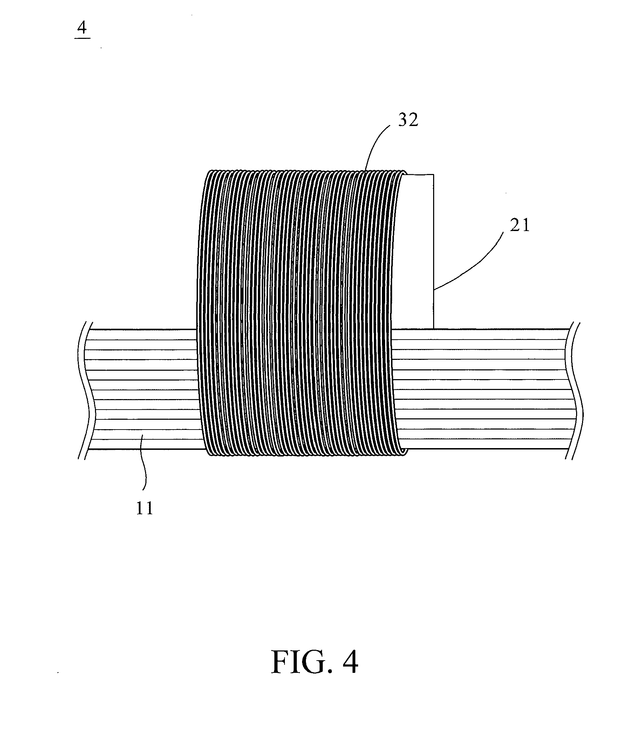

In reference to the second embodiment of the present invention shown in FIG. **4****,** there is also a woven electrical connection structure **4.** The woven electrical connection structure **4** also comprises a first conductive yarn **11** and a conductor **21.** The second embodiment differs from the first embodiment mainly in that the woven electrical connection structure **4** further comprises a fastening string **32.** The conductor **21** is directly stacked on the first conductive yarn **11** to directly make electrical contact with the first conductive yarn **11,** and is then sewn and wound around the first conductive yarn **11** by means of the fastening string **32.** Such a weaving method can achieve the purpose of fastening on the one hand and; on the other hand, the method can reduce contact of the conductor **21** with the exterior to ensure that electrical signal transmission is free of interference, thereby, protecting the electrical component.

The weaving and winding method used in this embodiment may be tatting, knitting, machine sewing, needling, hand sewing or stitching, by which the fastening string **32** is sewn and wound around both the conductor **21** and the first conductive yarn **11** that are stacked together. In other implementations, an adhesive may also be applied between the conductor and the first conductive yarn to adhere the conductor **21** to the first conductive yarn **11,** thereby, enhancing the overall firmness, conductivity or insulativity. The adhesive may be a conductive adhesive or an insulative adhesive as needed. In this embodiment, the fastening string **32** may be a conductive yarn, a mixed yarn of conductive fibers and non-conductive fibers or a non-conductive yarn. Other component arrangements, choice and use of materials and combinations are all similar to those of the previous embodiment, and thus, will not be further described herein.

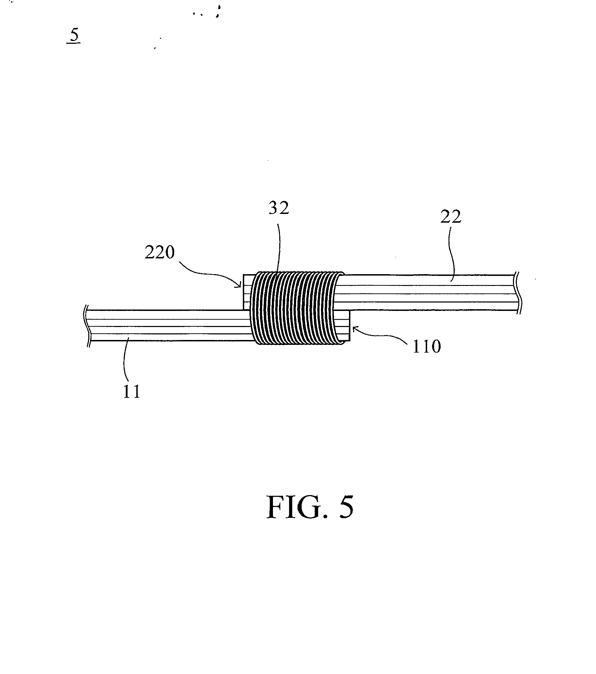

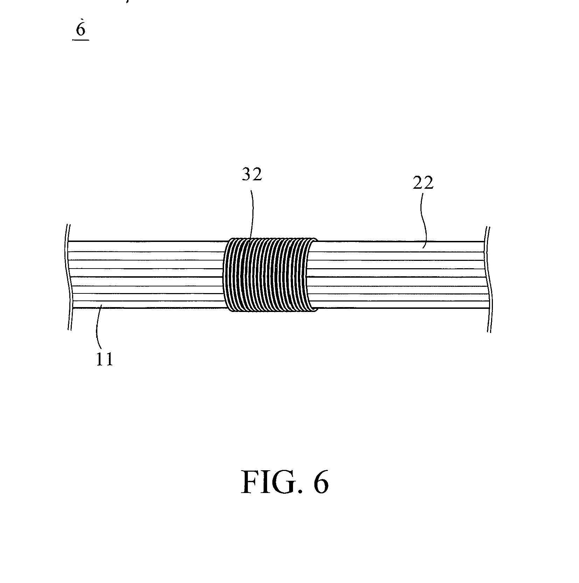

The woven electrical connection structures **5, 6** shown in **FIG. 5** and **FIG. 6** are another two implementations of this embodiment. As shown in **FIG. 5** and **FIG. 6****,** the woven electrical connection structures **5, 6** have a second conductive yarn **22** that replaces the conductor **21** of the woven electrical connection structure **3.** First, with reference to **FIG. 5****,** in the woven electrical connection structure **5,** the first conductive yarn **11** has a first end **110,** while the second conductive yarn **22** has a second end **220.** The second end **220** of the second conductive yarn **22** is directly stacked onto the first end **110** of the first conductive yarn **11** so that the first conductive yarn **11** and the second conductive yarn **22** make direct contact with and are electrically connected to each other. Then, the fastening string **32** is sewn and wound around both ends **110, 220** that are stacked together.

The woven electrical connection structure **6** shown in **FIG. 6** differs from the woven electrical connection structure **5** shown in **FIG. 5** in that the first conductive yarn **11** comes into contact at the middle part thereof with a middle part of the second conductive yarn **22,** and then the two middle parts are sewn by means of the fastening string **32.** It shall be appreciated that the interfaces at which the first conductive yarn **11** and the second conductive yarn **22** come into contact with each other can all achieve the purpose of the electrical connection. A user may suitably use, as necessary, an insulation material or an adhesive to cover the part that does not need to come into contact to form an electrical connection, thereby, avoiding the problem of short-circuiting.

Likewise, other examples of this implementation may also apply an adhesive between the first end of the first conductive yarn and the second end of the second conductive yarn to adhere the two conductive yarns together, thereby, enhancing the overall firmness, conductivity or insulativity; and the adhesive may be a conductive adhesive or an insulative adhesive as needed. Furthermore, the fastening string **32** may be a conductive yarn, a mixed yarn of conductive fibers and non-conductive fibers or a non-conductive yarn. Other component arrangements, choice and use of materials and combinations are all similar to those of the previous embodiment, and thus, will not be further described herein.

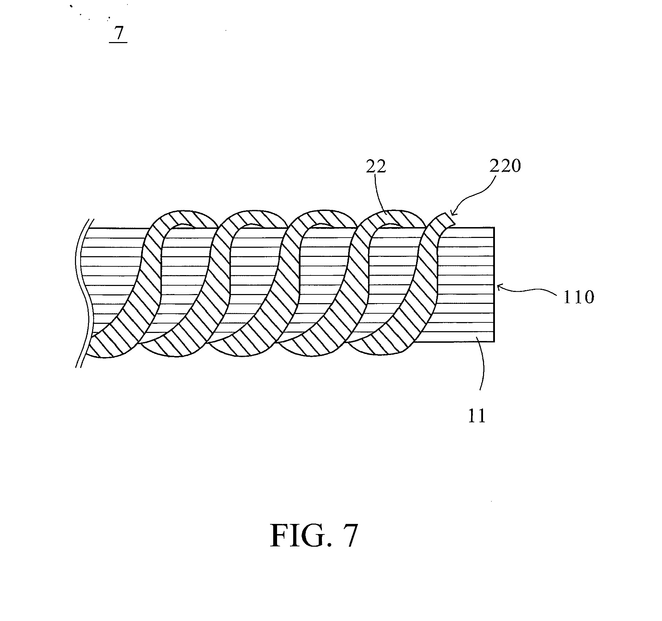

In addition to the first embodiment and the second embodiment described above, the present invention further has a third embodiment. As shown in **FIG. 7****,** in a woven electrical connection structure 7 of the third embodiment, a second conductive yarn **22** is wound around a first conductive yarn **11** to form an electrical connection therebetween directly. In this embodiment, the first end **110** of the first conductive yarn **11** and second end **220** of the second conductive yarn **22** are wound around each other. In detail, the first conductive yarn **11** has a first end **110,** while the second conductive yarn **22** has a second end **220;** and therefore, in this embodiment, the second end **220** of the second conductive yarn **22** is wound around the first end **110** of the first conductive yarn **11** to form an electrical connection therebetween directly. In other words, this embodiment can achieve an electrical connection by simply winding the first conductive yarn **11** and the second conductive yarn **22** around each other through weaving.

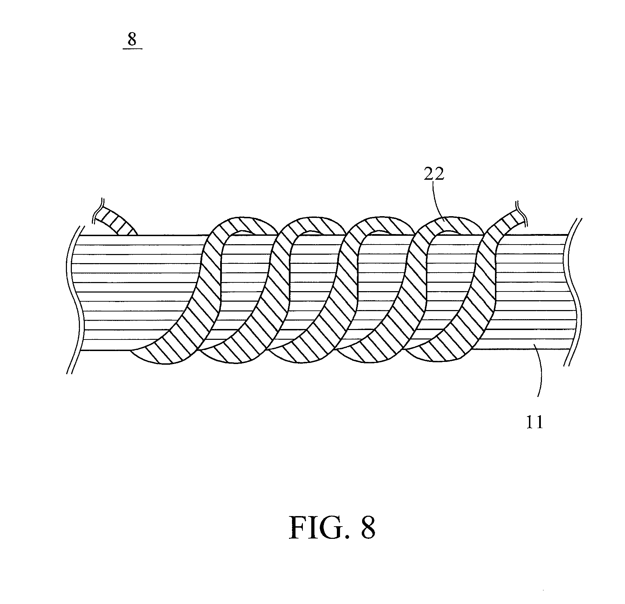

The third embodiment may also have other implementations such as a woven electrical connection structure **8** shown in **FIG. 8****.** The woven electrical connection structure **8** differs from the woven electrical connection structure **7** only in that the second conductive yarn **22** is wound at the middle portion or any portion thereof around some line segment of the first conductive yarn **11,** rather than having both conductive yarns wound at the ends thereof as shown in **FIG. 7****.**

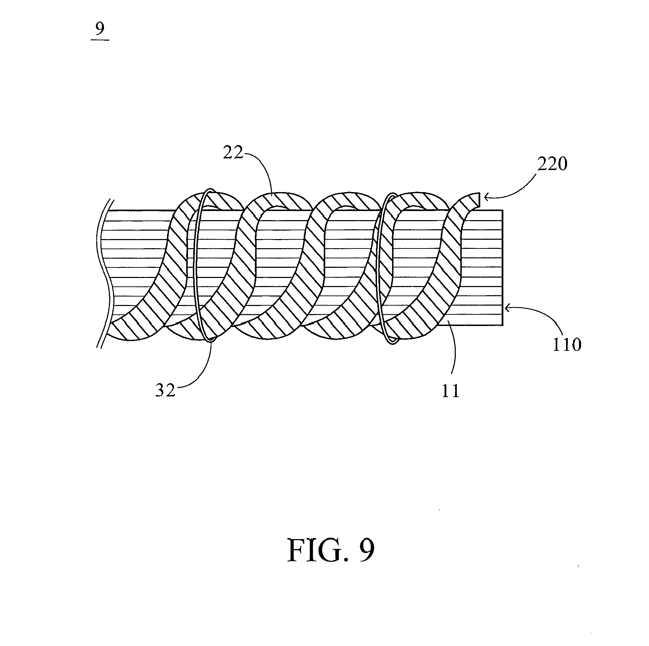

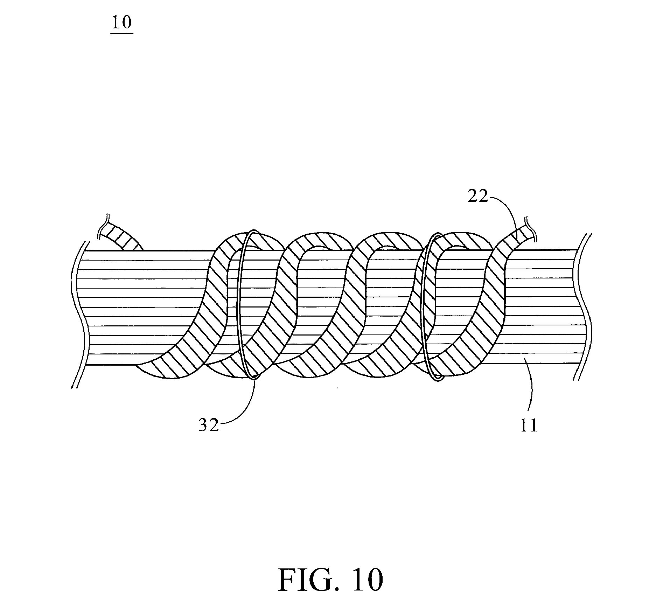

With reference to **FIGs. 9** and **10****, ,** the third embodiment may also use a plurality of fastening strings **32** for further securing the electrical connection between the conductive yarns, as shown by woven electrical connection structures **9, 10** of **FIGs. 9** and **10****.** As compared to the woven electrical connection structure **7** shown in **FIG. 7****,** the woven electrical connection structure **9** shown in **FIG. 9** is additionally provided with two fastening strings **32** to secure the electrical connection formed by winding the second conductive yarn **22** around the first conductive yarn **11.** Similarly, as compared to the woven electrical connection structure **8** shown in **FIG. 8****,** the woven electrical connection structure **10** shown in **FIG. 10** is additionally provided with two fastening strings **32** to secure the electrical connection formed by winding the second conductive yarn **22** around the first conductive yarn **11.** People skilled in the art may also use a single fastening string or a larger number of fastening strings for winding purposes. Other structures, arrangement and use of materials and connection relationships in other implementations of the third embodiment are as described above, and thus, will not be further described herein.

According to the above descriptions, the present invention provides a method of connecting two conductive yarns, conductive wires or conductors through weaving. Such a connecting method can not only allow the conductive wires, the conductive yarns or the conductors to be combined with textiles more closely, but also eliminate steps of soldering and adhesive dispensing. Thereby, textiles and electronic products can be combined flexibly, and the aesthetic appearance and utility of the textiles are further improved.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A woven electrical connection structure, comprising:
a first conductive yarn;
a conductor; and
a connecting conductive wire, being sewn and wound around the first conductive yarn;
wherein the conductor is directly stacked on the connecting conductive wire, and is electrically connected to the first conductive yarn through the connecting conductive wire.

2. The woven electrical connection structure as claimed in claim 1, wherein the first conductive yarn has an end, which the connecting conductive wire is sewn and wound around.

3. The woven electrical connection structure as claimed in claim 1, further comprising an adhesive, which is applied between the conductor and the connecting conductive wire to adhere the connecting conductive wire to the conductor.

4. The woven electrical connection structure as claimed in claim 1, wherein the conductor is a second conductive yarn, which is directly stacked on the connecting conductive wire, and is electrically connected to the first conductive yarn through the connecting conductive wire.

5. The woven electrical connection structure as claimed in claim 4, wherein the second conductive yarn has an end, which is directly stacked on the connecting conductive wire, and is electrically connected to the first conductive yarn through the connecting conductive wire.

6. The woven electrical connection structure as claimed in claim 4, wherein the first conductive yarn and/or the second conductive yarn is a metal yarn.

7. A woven electrical connection structure, comprising:
a first conductive yarn;
a conductor, being directly stacked on and electrically connected to the first conductive yarn; and
a fastening string, being sewn and wound around both the first conductive yarn and the conductor.

8. The woven electrical connection structure as claimed in claim 7, wherein the first conductive yarn has a first end, and the conductor is directly stacked on and electrically connected to the first end.

9. The woven electrical connection structure as claimed in claim 7, wherein the fastening string is a conductive yarn, a mixed yarn of conductive fibers and non-conductive fibers or a non-conductive yarn.

10. The woven electrical connection structure as claimed in claim 7, further comprising an adhesive, which is applied between the conductor and the first conducive yarn to adhere the conductor to the first conductive yarn.

11. The woven electrical connection structure as claimed in claim 7, wherein the conductor is a second conductive yarn, which is directly stacked on and directly electrically connected to the first conductive yarn.

12. The woven electrical connection structure as claimed in claim 11, wherein the conductor is a second conductive yarn, and the second conductive yarn has a second end, which is directly stacked on the first conductive yarn so that the second conductive yarn is electrically connected to the first conductive yarn directly.

13. The woven electrical connection structure as claimed in claim 11, wherein the first conductive yarn and/or the second conductive yarn is a metal yarn.

14. A woven electrical connection structure, comprising:
a first conductive yarn; and
a second conductive yarn, being wound around and directly electrically connected to the first conductive yarn.

15. The woven electrical connection structure as claimed in claim 14, further comprising a fastening string, which is sewn and wound around both the first conductive yarn and the second conductive yarn.
